# EUROPÄISCHE PATENTSCHRIFT

(11) **EP 1 802 180 B1**
(45) Veröffentlichungstag und Bekanntmachung des Hinweises auf die Patenterteilung: **31.07.2013**
(21) Anmeldenummer: 06023143.8
(22) Anmeldetag: 07.11.2006
(51) Int. Cl.: H05K 1/11

(54) **Verfahren zur Befestigung- und Kontaktierung eines Substrates**
Process for holding and contacting a substrate
Procédé de contact et de fixation d'un substrat

(30) Priorität: 11.11.2005 DE 102005053930
(43) Veröffentlichungstag der Anmeldung: 27.06.2007
(73) Patentinhaber: Rohde & Schwarz GmbH & Co. KG, 81671 München (DE)
(72) Erfinder: Bayer, Alexander, 81547 München (DE); Leipold, Markus, 84424 Isen (DE)
(74) Vertreter: Körfer, Thomas

(56) Entgegenhaltungen:
- DE-A1- 3 113 540
- US-A- 5 944 540

## Beschreibung

Die Erfindung bezieht sich auf ein Verfahren zum Befestigen eines Substrats einer Dünnschicht- oder Dickschichtschaltung an einem Kontaktsockel oder Gehäuse und zur Herstellung eines elektrischen Kontakts zwischen einer auf dem Substrat vorgesehenen Leitung und dem Kontaktsockel oder Gehäuse.

Zur Befestigung eines Substrats einer Dünnschicht- oder Dickschichtschaltung, welche bei verhältnismäßig hohen Frequenzen von bis zu 70 GHz betrieben wird, wurde bisweilen ein Schrauben umfassender Kontaktsockel verwendet. Die Schrauben dienen dazu, das Substrat auf eine am Kontaktsockel für das Substrat vorgesehene Auflagefläche zu drücken, so dass ein elektrischer Kontakt zwischen der Schaltung und der Auflagefläche des Kontaktsockels, beispielsweise zur Massekontaktierung der Schaltung, geschlossen wird.

Im Gegensatz dazu ist in der DE 199 26 453 A1 eine Vorrichtung offenbart, bei welcher ein Substrat einer Dünnschichtschaltung mittels einer oder mehrerer sich über das Substrat erstreckender Leisten und an diesen angeordneten Druckstücken auf eine Auflagefläche eines Sockels gedrückt ist. Mit den an den Leisten angeordneten Druckstücken als Druckkörper wird eine gleich verteilte Druckfläche auf der Substratoberfläche erzielt, wohingegen die Benutzung von Schrauben als Druckkörper, welche einzelne Druckpunkte bilden, sich schädigend auf das Substrat auswirken kann. Die Leisten selbst sind am Sockel über Haltehaken eingerastet und drücken mittels Druckstücken das Substrat auf den Boden des Sockels. Zur Befestigung des Substrats sind für die in DE 199 26 453 A1 offenbarte Vorrichtung allerdings eine vergleichsweise große Anzahl an Einzelteilen, wie beispielsweise Leisten, Druckstücke und Haltehaken erforderlich. Eine große Anzahl an Einzelteilen hat vergleichsweise hohe Herstellungs- und Montagekosten zur Folge. Zum Andrücken des Substrats mit den Druckstücken sind des Weiteren Platzbereiche mit erheblicher Größe auf der Substratoberfläche freizuhalten. Zudem besteht auch bei der in DE 199 26 453 A1 offenbarten Vorrichtung die Gefahr, dass es durch Andrücken des Substrats mittels der Druckstücke zu einer Verbiegung, wenn nicht gar zu Rissen im Substrat kommt.

Da sich die Befestigung des Substrats mit auf dieses drückenden Schrauben oder Druckstücken bei sehr dünnen Substraten (z.B. Substratdicke von 127 µm) schädigend auswirken kann, wurde bislang auch ein verfahren angewendet, nach welchem das Substrat auf den Kontaktsockel gelötet oder mit leitendem Kleber geklebt wird. Durch das Löten oder Kleben besteht aber die Gefahr der Verunreinigung der Substratoberfläche. Des Weiteren ist eine infolge der Löt- oder Klebeverbindung zwischen dem Substrat und dem Kontaktsockel entstehende Löt- oder Klebeschicht in ihrer Dicke nicht exakt reproduzierbar, so dass dafür zusätzliche Toleranzen bei der Befestigung des Substrats in Kauf genommen werden müssen. Zudem ist die Entfernung des einmalig angelöteten oder angeklebten Substrats mit vergleichsweise hohem Arbeitszeit- und Kostenaufwand verbunden. Ferner kann es durch thermische Spannungen zwischen Substrat und Sockel, welche durch Fremdeinwirkung entstehen, bei bestehendem festen Löt- oder Klebeverbund des Substrats mit dem Sockel im Extremfall zu einem Substratbruch kommen.

Die DE 31 13 540 A1 offenbart eine Leiterplatte, bei der im Wechsel kuppenförmige Kontaktelemente angebracht sind. Als Gegenkontakt dient eine Kontaktschiene. Diese weist Schenkel auf, welche um die Leiterflächen der Leiterplatte greifen. Die Schenkel dienen zusammen mit den Kuppen der Kontaktelemente als elektrischer Verbinder und Halterung der Leiterplatte. Beim Einschieben in die Kontaktschiene wird das Randgebiet der Leiterplatte wellig verformt und/oder die Schenkel der Kontaktschiene werden federn ausgelenkt.

In der US 5,944,540 weist eine Leiterplatte an einem Ende oder an einer Kante Kontaktflächen auf. Bei Einführen der Leiterplatte in einen Halteschuh finden vorgeformte, biegbare Federn Kontakt mit den Kontaktflächen. Für die Herstellung des Kontakts wird die Leiterplatte, welche eine Speichersteckkarte sein kann, in einen Halteschuh eingeführt.

Das Dokument US 4,186,062 beschreibt wie Anschlussstifte einer gedruckten Leiterplatte plattiert werden können. Bei Ausbildung als Steckkarten sind sie an einem Rand mit Anschlussstiften versehen, die eine Nickel- und Goldplattierung erfordern. Die meisten gedruckten Leiterplatten sind mit einem Lot versehen.

Der Erfindung liegt die Aufgabe zugrunde, ein Verfahren zum besonders einfachen und materialschonenden Befestigen eines Substrats einer Dünnschicht- oder Dichschichtschaltung an einem Sockel oder Gehäuse und zur Herstellung eines besonders zuverlässigen und für Hochfrequenzanwendungen besonders geeigneten elektrischen Kontakts der eingangs erwähnten Art anzugeben.

Diese Aufgabe wird erfindungsgemäß gelöst durch die Merkmale des Anspruchs 1. Vorteilhafte Weiterbildungen sind Gegenstand der hierauf rückbezogenen Unteransprüche.

So umfasst das Verfahren zum Befestigen eines Substrats einen Schlitz, in welchen das Substrat zur Ausbildung einer formschlüssigen Verbindung einführbar und darin nach Art einer Klemmverbindung reversibel fixierbar ist, wobei die Klemmverbindung durch Ausbildung eines Gehemmes gebildet ist, welches durch Zusammenwirkung zumindest eines auf dem Substrat vorgesehenen Kontakthöckers mit einer Seitenwand des Schlitzes am Kontaktsockel oder im Gehäuse entsteht. Der Kontakthöcker dient zusätzlich zum Schließen eines elektrischen Kontaktes zwischen einer auf dem Substrat vorgesehenen Leitung und dem Kontaktsockel oder Gehäuse.

Dabei ist unter einer formschlüssigen Verbindung eine Art Stecker-Steckdose Verbindung zu verstehen, bei welcher der äußere Umriß des Steckers - des Substrats - geringfügig kleiner dimensioniert ist als der innere Umriß der Steckdose - des Schlitzes. Die auf dem Substrat aufgebrachten Kontakthöcker verdrücken sich beim Einführen des Substrat in den Schlitz. Durch die formschlüssige Verbindung fallen zwischen dem Substrat und dem Schlitz auftretende Spalte vergleichsweise klein aus.

Die mit der Erfindung erzielten Vorteile bestehen insbesondere darin, dass zur Befestigung des Substrats am Kontaktsockel oder Gehäuse das Substrat selbst keiner mechanischen Belastung ausgesetzt ist. Des Weiteren ist eine Montage und Demontage des Substrats beliebig oft und vergleichsweise schnell möglich. Zudem sind keine zusätzlichen, am Substrat oder am Kontaktsockel oder Gehäuse zu befestigenden Einzelteile wie Leisten, Federn oder andere Verbindungselemente zur Befestigung des Substrats am Kontaktsockel oder Gehäuse erforderlich.

Ferner wird durch das den Kontakthöcker und die Seitenwand des Schlitzes umfassende Gehemme ein besonders zuverlässiger elektrischer Kontakt zwischen der Schaltung des Substrats und dem Kontaktsockel oder Gehäuse geschlossen. Außerdem treten durch die Art der Befestigung des Substrats am Kontaktsockel oder Gehäuse und durch die vorteilhafte Dimensionierung des Substrats und des Schlitzes zur Ausbildung der formschlüssigen Verbindung vergleichsweise kleine Spalte zwischen dem Substrat und dem Schlitz auf, so dass Hochfrequenzprobleme, wie beispielsweise die Ausbreitung höherer Moden, vermieden werden. Darüber hinaus werden durch die Anordnung des Kontakthöckers, welcher auf dem Substrat aufgebracht und mit der elektrischen Leitung auf dem Substrat elektrisch leitend verbunden sowie mit dem Kontaktsockel oder Gehäuse elektrisch leitend verbindbar ist, besonders hervorragende Hochfrequenzeigenschaften, wie beispielsweise kurze Leitungswege, erzielt.

Gemäß einer vorteilhaften Ausgestaltung sind auf dem Substrat mehrere zueinander beabstandete Kontakthöcker angeordnet. Durch eine derartige Anordnung von Kontakthöckern ist eine besonders gute mechanische Anbindung des Substrats an den Kontaktsockel oder das Gehäuse sichergestellt und der elektrische Kontakt zwischen der Leitung auf dem Substrat und dem Kontaktsockel oder Gehäuse besonders zuverlässig schließbar. Durch die beabstandete Anordnung der Kontakthöcker auf dem Substrat ist außerdem sichergestellt, dass sich die Kontakthöcker, welche zur Einführung des Substrats in den Schlitz zur Ausbildung des Gehemmes mit der Seitenwand des Schlitzes zusammenwirken und sich dadurch verdrücken, nicht gegenseitig beeinflussen. Einem möglichen Schaden an den Kontakthöckern und an der Substratoberfläche wird durch die beabstandete Anordnung der Kontakthöcker entgegengewirkt.

In zweckmäßiger Weiterbildung erstrecken sich die auf dem Substrat zueinander beabstandet und in einer Reihe ausgebildeten Kontakthöcker über eine Schlitzbreite quer zu einer Einführrichtung des Substrats in den Schlitz. Dadurch ist die mechanische Festigkeit der Klemmverbindung zur Befestigung des Substrats am Kontaktsockel oder Gehäuse über die Schlitzbreite gewährleistet.

Des Weiteren ist es zweckmäßig, den bzw. die Kontakthöcker vergleichsweise großflächig auszubilden, oder viele kleine Kontakthöcker anzubringen. Dadurch wird ein besonders sicherer elektrischer Kontakt zwischen der Leitung auf dem Substrat und dem Kontaktsockel oder Gehäuse sowie eine erhöhte mechanische Festigkeit der Klemmverbindung gewährleistet. Die platzeinnehmende Ausbildung der Kontakthöcker dient auch zur Vermeidung von Hochfrequenzproblemen, da die zwischen dem Substrat und der Seitenwand des Schlitzes auftretenden Spalte durch die Kontakthöcker größtenteils ausgefüllt werden.

Um eine vergleichsweise schnelle und materialschonende Montage zu gewährleisten, ist es zweckmäßig, an einem Öffnungsrand des Schlitzes des Kontaktsockels oder Gehäuses eine Einführschräge vorzusehen. Diese kann als Fase oder als Radius ausgestaltet sein. Gemäß einer vorteilhaften Ausgestaltung ist der gesamte Öffnungsrand als Einführschräge ausgeführt.

Um zusätzlich eine besonders einfache und zuverlässige Befestigung des Substrats, mit welcher eine schnelle Montage und Demontage des Substrats in besonders einfacher Art und Weise sowie servicefreundlich möglich ist, zu gewährleisten, ist das mit dem Schlitz eine formschlüssige Verbindung eingehende Substrat plattenförmig ausgeführt. Bei dem plattenförmig ausgeführten Substrat ist es weiter zweckmäßig, mehrere Kontakthöcker an gegenüberliegenden Seitenflächen des Substrats auszubilden, welche in der Klemmverbindung des Substrats mit dem Gehäuse Seitenwänden des Schlitzes benachbart angeordnet sind. Die auf den Seitenflächen ausgebildeten Kontakthöcker wirken mit den entsprechenden Seitenwänden des Schlitzes zusammen.

Weiter ist es zweckmäßig, das Substrat derart auszubilden, dass es von mehreren Kontaktsockeln oder Gehäuseteilen gleichzeitig gehalten werden kann. Dazu weist das Substrat mehrere mit Kontakthöckern versehene Abschnitte auf, an welchen das Substrat befestigbar ist.

Dadurch, dass die auf dem Substrat zueinander beabstandet angeordneten Kontakthöcker elektrisch leitend über die Leitung miteinander verbunden sind, ist eine Verkürzung von Leitungswegen erzielt. Unter Leitungswege sind hier diejenigen Wege zu verstehen, welche der Strom von einem Bauelement auf der Schaltung entlang der Leitung bis zum Kontaktsockel bzw. Gehäuse zurücklegt. Die Leitungswege sind weiter dadurch verkürzbar, dass das Substrat an mehreren Abschnitten, welche Kontakthöcker zur mechanischen Befestigung aufweisen, mit Gehäuseteilen gehalten ist. Ist die elektrische Leitung beispielsweise als Masseleitung der Schaltung ausgebildet und dienen die Kontakthöcker als Massekontaktierung zum Kontaktsockel bzw. Gehäuse, so werden durch die elektrisch leitende Verbindung der Kontakthöcker untereinander Masseumwege vermieden.

Außerdem ist es zweckmäßig zur Vereinfachung der mechanischen Fertigung am Gehäuse einen Kontaktsockel vorzusehen, in den der Schlitz gesägt werden kann.

In zweckmäßiger Weiterbildung ist bzw. sind der bzw. die Kontakthöcker durch Galvanisierung auf das Substrat aufgebracht. Mit Hilfe der Galvanotechnik ist es möglich, die Kontakthöcker besonders einfach in gewünschter Höckerbeabstandung und mit gewünschter Höckerdicke sowie Höckerdimensionierung auf dem Substrat auszubilden. Zur elektrisch leitenden Verbindung der Kontakthöcker untereinander und der auf dem Substrat vorgesehenen als Streifenleitung ausgeführten Leitung bedarf es somit keiner zusätzlichen Brückenbauelemente zwischen den Kontakthöckern und zwischen den Kontakthöckern und der Leitung.

Nachfolgend wird ein Ausführungsbeispiel der Erfindung anhand einer Zeichnung näher erläutert. Darin zeigen:
- Fig. 1: eine Draufsicht auf ein Substrat mit Kontakthöckern zur Befestigung an einem Gehäuse und
- Fig. 2: einen Querschnitt durch ein an zwei Gehäuseteilen mit Kontaktsockeln befestigtes Substrat.

Einander entsprechende Teile sind in allen Figuren mit den gleichen Bezugszeichen versehen.

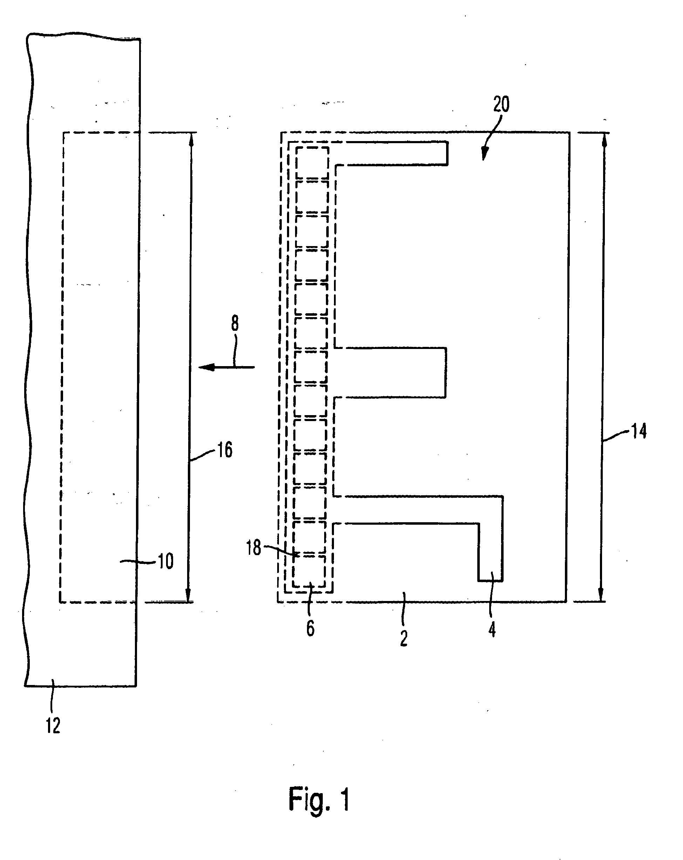

Dabei zeigt Fig. 1 eine Draufsicht auf ein Substrat 2 einer Dünnschichtschaltung, auf welchem eine als Streifenleitung ausgeführte elektrische Leitung 4 und Kontakthöcker 6, welche mit der Leitung 4 elektrisch leitend verbunden sind, angeordnet sind. Der gestrichelt dargestellte Bereich des Substrats 2 zeigt einen Abschnitt, welcher zur Befestigung des Substrats 2 in einer Einführrichtung 8 in einen Schlitz 10 eines Gehäuses 12 einführbar ist. Der Schlitz 10 des Gehäuses 12 ist durch eine gestrichelte Linie angedeutet.

Um die mechanische Festigkeit der Klemmverbindung zwischen dem Substrat 2 und dem Gehäuse 12 zu gewährleisten, sind die Kontakthöcker 6, welche mit einer in Fig. 1 nicht dargestellten Seitenwand des Schlitzes 10 zur Ausbildung der Klemmverbindung zusammenwirken, über eine Länge 14 des Substrats 2, welche einer Breite 16 des Schlitzes 10 entspricht, quer zur Einführrichtung 8 in Reihe zueinander beabstandet auf dem Substrat 2 ausgebildet. Um Spalte 18, welche zwischen unmittelbar benachbarten Kontakthöckern 6 auftreten, vergleichsweise klein zu gestalten, sind die Kontakthöcker 6 derart beabstandet angeordnet, dass sie sich beim Einführen des Substrats 2 in den Schlitz 10 zur Ausbildung des Gehemmes zwar verdrücken können aber nicht gegenseitig beeinflussen. Durch die platzeinnehmende Ausbildung der Kontakthöcker 6 wird einem möglicherweise auftretenden Schaden an den Kontakthöckern 6 und an einer Substratoberfläche 20 entgegengewirkt.

Im in Fig. 1 gezeigten Ausführungsbeispiel ist die Leitung 4 als Masseleitung der Schaltung vorgesehen. Die Kontakthöcker 6 sind über die Leitung 4 elektrisch leitend miteinander verbunden. Durch die elektrisch leitende Verbindung der Kontakthöcker 6 sind Leitungswege auf der Schaltung verkürzt und Masseumwege vermieden, wodurch verbesserte Hochfrequenzeigenschaften erzielt werden.

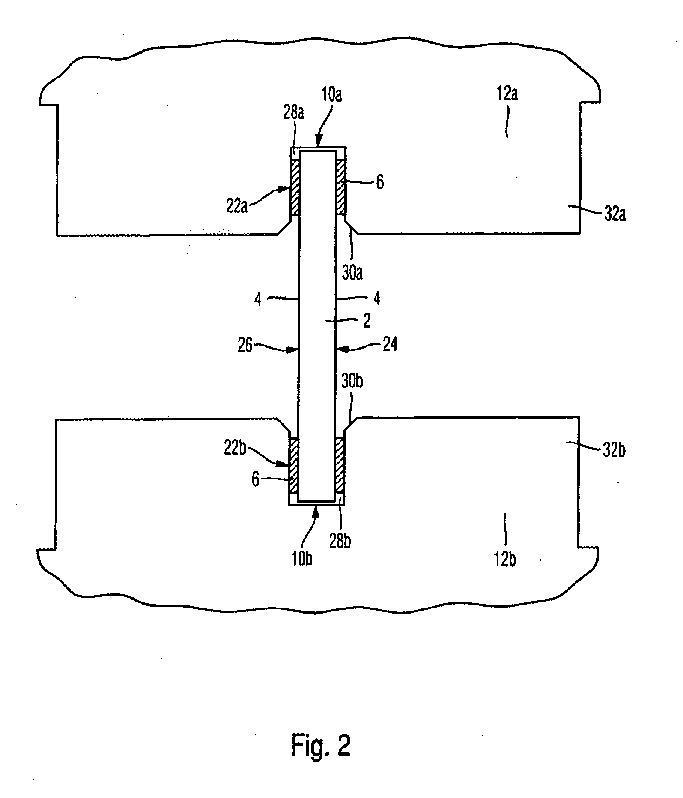

Fig. 2 zeigt schematisch einen Querschnitt des Substrats 2, welches an zwei Gehäuseteilen 12a, 12b mit Kontaktsockeln 32a, 32b befestigt ist. Dazu weisen die Kontaktsockel 32a, 32b jeweils einen Schlitz 10a, 10b auf, in welchen das Substrat 2 einführbar ist und mit dem jeweiligen Kontaktsockel 32a,32b eine formschlüssige Verbindung eingeht. Die formschlüssige Verbindung zwischen dem Substrat 2 und dem jeweiligen Kontaktsockel 32a,32b ist dadurch realisiert, dass der innere Umriss des jeweiligen Schlitzes 10a,10b geringfügig größer als äußere Umriss des Substrats 2 ausgebildet ist. Zur Befestigung des Substrats 2 an dem jeweiligen Kontaktsockel 32a,32b ist eine Klemmverbindung vorgesehen, welche dadurch ausgebildet ist, dass die Kontakthöcker 6 beim Einführen des Substrats 2 in den jeweiligen Schlitz 10a,10b mit einer den jeweiligen Kontakthöckern 6 gegenüberliegenden Seitenwand 22a,22b des jeweiligen Schlitzes 10a, 10b zur Ausbildung der die Klemmverbindung bewirkenden Gehemme zusammenwirken.

Um die mechanische Festigkeit der Klemmverbindung zu erhöhen, weist das Substrat 2 an gegenüberliegenden Breitseiten 24,26 Kontakthöcker 6 auf.

Zusätzlich zum Spalt 18 zwischen zwei unmittelbar benachbarten Kontakthöckern 6, der in Fig. 1 gezeigt ist, tritt auch ein Spalt 28a,28b zwischen dem Substrat 2 und dem jeweiligen Schlitz 10a, 10b auf. Um einen einwandfreien elektrischen Kontakt zwischen der Dünnschichtschaltung und dem Kontaktsockel 12 herzustellen, sind die Kontakthöcker 6 vergleichsweise platzeinnehmend auf dem Substrat 2 ausgebildet. Im Ausführungsbeispiel sind die Kontakthöcker 6 vorzugsweise plattenförmig ausgebildet, so dass, wie in Fig. 2 gezeigt, der Spalt 28a,28b mit den Kontakthöckern 6 größtenteils ausgefüllt ist, wodurch Hochfrequenzprobleme vermieden werden.

Ist das Substrat 2, wie in Fig. 2 gezeigt, von zwei Kontaktsockeln gehalten, ist einerseits die Befestigung des Substrats 2 sichergestellt. Andererseits verkürzen sich die Leitungswege zwischen der Schaltung des Substrats 2 und dem jeweiligen Kontaktsockel 32a,32b, da sowohl die Kontakthöcker 6 am Schlitz 10a als auch die Kontakthöcker 6 am Schlitz 10b mit der Leitung 4 elektrisch leitend verbunden sind.

Um ein besonders sicheres und Material schonendes Einführen des Substrats 2 in den jeweiligen Kontaktsockel 32a,32b zu gewährleisten, sind an Öffnungsrändern der Schlitze 10a,10b zusätzlich Einführschrägen 30a,30b vorgesehen.

## Patentansprüche

1. Verfahren zum Befestigen eines Substrats (2) einer Dünnschicht- oder Dickschichtschaltung an einem einen Schlitz (10, 10a, 10b) aufweisenden Kontaktsockel oder Gehäuseteil (12,12a,12b) welche einen elektrischen Kontakt zwischen einer auf dem Substrat (2) vorgesehenen elektrischen Leitung (4) und dem Kontaktsockel oder Gehäuseteil (12,12a,12b) herstellt,
wobei das Substrat (2) in den Schlitz (10, 10a, 10b) eingeführt wird und eine formschlüssige Verbindung mit dem Schlitz (10, 10a, 10b) bildet und in diesem reversibel derart befestigt wird, dass zumindest ein auf dem Substrat (2) ausgebildeter und mit der Leitung (4) elektrisch leitend verbundener Kontakthöcker (6) mit einer Seitenwand (22a,22b) des Schlitzes (10, 10a, 10b) zur Ausbildung eines elektrischen Kontakts zusammenwirkt, indem der äußere Umriss des Substrats (2) so geringfügig kleiner dimensioniert wird als der innere Umriss des Schlitzes (10, 10a, 10b), dass die auf dem Substrat (2) aufgebrachten Kontakthöcker (6) beim Einführen des Substrats (2) in den Schlitz (10, 10a, 10b) verdrückt werden, und indem die Kontakthöcker (6) plattenförmig ausgebildet werden, so dass ein Spalt (28a, 28b) zwischen dem Substrat (2) und dem jeweiligen Schlitz (10a, 10b) mit den Kontakthöckern (6) größtenteils ausgefüllt wird.

2. Verfahren nach Anspruch 1,
bei welchem auf dem Substrat (2) die Kontakthöcker (6) beabstandet ausgebildet werden.

3. Verfahren nach Anspruch 1 oder 2,
bei welchem auf dem Substrat (2) mehrere in Reihe quer zu einer Einführrichtung (8) des Substrats (2) angeordnete Kontakthöcker (6) ausgebildet werden.

4. Verfahren nach einem der Ansprüche 1 bis 3,
bei welchem am Schlitz (10, 10a, 10b) des Kontaktsockels bzw. Gehäuseteils (12,12a,12b) eine Einführschräge in Form einer Fase oder eines Radius (30a, 30b) vorgesehen wird.

5. Verfahren nach einem der Ansprüche 1 bis 4,
bei welchem das Substrat (2) plattenförmig oder zylinderförmig ausgeführt wird.

6. Verfahren nach Anspruch 5,
bei welchem der bzw. die Kontakthöcker (6) auf gegenüberliegenden Seitenflächen (18,20) des Substrats (2) ausgebildet ist bzw. werden.

7. Verfahren nach einem der Ansprüche 1 bis 6,
bei welchem das Substrat (2) zur Befestigung an mehreren Kontaktsockeln bzw. Gehäuseteilen (12,12a,12b) ausgebildet wird.

8. Verfahren nach Anspruch 2,
bei welchem der Kontakthöcker (6) mit jedem weiteren Kontakthöcker über die Leitung (4) elektrisch leitend verbunden wird.

9. Verfahren nach einem der Ansprüche 1 bis 8,
bei welchem der bzw. die Kontakthöcker (6) durch Galvanisierung auf das Substrat (2) aufgebracht wird bzw. werden.

10. Verfahren nach einem der Ansprüche 1 bis 9,
bei dem ein oder mehrere Kontaktsockel an einem oder mehreren Gehäuseteilen angebracht wird /werden.

## Claims

1. Method for fastening a substrate (2) of a thin-film or thick-film circuit to a contact base or housing part (12, 12a, 12b) which has a slot (10, 10a, 10b), this establishing electrical contact between an electrical line (4), which is provided on the substrate (2), and the contact base or housing part (12, 12a, 12b),
wherein the substrate (2) is inserted into the slot (10, 10a, 10b) and forms an interlocking connection with the slot (10, 10a, 10b) and is fastened in the said slot in a reversible manner in such a way that at least one contact bump (6) which is formed on the substrate (2) and is electrically conductively connected to the line (4) interacts with a side wall (22a, 22b) of the slot (10, 10a, 10b) for forming an electrical contact by the outer contour of the substrate (2) being of such slightly smaller dimensions in relation to the inner contour of the slot (10, 10a, 10b) that the contact bumps (6) which are fitted to the substrate (2) are thinned out when the substrate (2) is inserted into the slot (10, 10a, 10b), and by the contact bumps (6) being of plate-like design, with the result that a gap (28a, 28b) between the substrate (2) and the respective slot (10a, 10b) is filled for the most part with the contact bumps (6).

2. Method according to Claim 1, in which the contact bumps (6) are formed on the substrate (2) such that they are spaced apart.

3. Method according to Claim 1 or 2, in which a plurality of contact bumps (6) which are arranged in series transverse to an insertion direction (8) of the substrate (2) are formed on the substrate (2).

4. Method according to one of Claims 1 to 3, in which an insertion slope in the form of a chamfer or a radius (30a, 30b) is provided on the slot (10, 10a, 10b) in the contact base or housing part (12, 12a, 12b).

5. Method according to one of Claims 1 to 4, in which the substrate (2) is of plate-like or cylindrical design.

6. Method according to Claim 5, in which the contact bump or bumps (6) is/are formed on opposite side faces (18, 20) of the substrate (2).

7. Method according to one of Claims 1 to 6, in which the substrate (2) is designed to be fastened to a plurality of contact bases or housing parts (12, 12a, 12b).

8. Method according to Claim 2, in which the contact bump (6) is electrically conductively connected to each further contact bump via the line (4).

9. Method according to one of Claims 1 to 8, in which the contact bump or bumps (6) is/are fitted to the substrate (2) by electroplating.

10. Method according to one of Claims 1 to 9, in which one or more contact bases is/are applied to one or more housing parts.

## Revendications

1. Procédé de fixation d'un substrat (2) d'un circuit à couche mince ou à couche épaisse sur un socle de contact ou une partie de boîtier (12, 12a, 12b) présentant une fente (10, 10a, 10b) qui génère un contact électrique entre une ligne électrique (4) prévue sur le substrat (2) et le socle de contact ou la partie de boîtier (12, 12a, 12b),
dans lequel le substrat (2) est inséré dans la fente (10, 10a, 10b) et forme une liaison mécanique avec la fente (10, 10a, 10b) et est fixé dans celle-ci de façon réversible de telle sorte qu'au moins un plot de contact (6) réalisé sur le substrat (2) et relié de façon électriquement conductrice à la ligne (4) coopère avec une paroi latérale (22a, 22b) de la fente (10, 10a, 10b) en vue de la formation d'un contact électrique, dans lequel la périphérie extérieure du substrat (2) est de dimension légèrement plus petite que la périphérie interne de la fente (10, 10a, 10b), de sorte que les plots de contact (6) disposés sur le substrat (2) sont enfoncés lors de l'insertion du substrat (2) dans la fente (10, 10a, 10b), et dans lequel les plots de contact (6) sont réalisés sous forme de plaque, de sorte qu'un espace (28a, 28b) entre le substrat (2) et la fente respective (10a, 10b) est remplie en grande partie par les plots de contact (6).

2. Procédé selon la revendication 1,
dans lequel les plots de contact (6) sont réalisés écartés les uns des autres sur le substrat (2).

3. Procédé selon la revendication 1 ou 2,
dans lequel plusieurs plots de contact (6) disposés en série transversalement à une direction d'insertion (8) du substrat (2) sont réalisés sur le substrat (2).

4. Procédé selon l'une des revendications 1 à 3,
dans lequel un plan incliné d'insertion sous la forme d'un chanfrein ou d'un rayon (30a, 30b) est prévu dans la fente (10, 10a, 10b) du socle de contact ou de la partie de boîtier (12, 12a, 12b).

5. Procédé selon l'une des revendications 1 à 4,
dans lequel le substrat est réalisé sous la forme d'une plaque ou sous la forme d'un cylindre.

6. Procédé selon la revendication 5,
dans lequel le ou les plots de contact (6) est ou sont réalisés sur les surfaces latérales opposées (18, 20) du substrat (2).

7. Procédé selon l'une des revendications 1 à 6,
dans lequel le substrat (2) est réalisé en vue de la fixation à plusieurs socles de contact ou parties de boîtier (12, 12a, 12b).

8. Procédé selon la revendication 2,
dans lequel le plot de contact (6) est relié de façon électriquement conductrice à chaque autre plot de contact par l'intermédiaire de la ligne (4).

9. Procédé selon l'une des revendications 1 à 8,
dans lequel le ou les plots de contact (6) est ou sont déposés par galvanisation sur le substrat (2).

10. Procédé selon l'une des revendications 1 à 9,
dans lequel un ou plusieurs socles de contact est/sont disposés sur une ou plusieurs parties de boîtier.
